# EUROPÄISCHE PATENTSCHRIFT

(11) **EP 3 357 099 B1**
(45) Veröffentlichungstag und Bekanntmachung des Hinweises auf die Patenterteilung: **08.09.2021**
(21) Anmeldenummer: 16738447.8
(22) Anmeldetag: 14.07.2016
(51) Int. Cl.: H01L 41/047, H01L 41/083

(54) **ELEKTROKERAMISCHES BAUELEMENT, INSBESONDERE VIELSCHICHT-PIEZOAKTOR**
ELECTROCERAMIC COMPONENT, IN PARTICULAR MULTILAYER PIEZO ACTUATOR
COMPOSANT ÉLECTROCÉRAMIQUE, EN PARTICULIER ACTIONNEUR PIÉZOÉLECTRIQUE MULTICOUCHE

(30) Priorität: 29.09.2015 DE 102015218701
(43) Veröffentlichungstag der Anmeldung: 08.08.2018
(73) Patentinhaber: Vitesco Technologies GmbH, 30165 Hannover (DE)
(72) Erfinder: LENK, Andreas, 01728 Bannewitz / OT Possendorf (DE); HAUBOLD, Jörg, 09212 Limbach-Oberfrohna (DE); HÄGLER, Christian, 92507 Nabburg (DE); WILDGEN, Andreas, 93152 Haugenried (DE); ZUMSTRULL, Claus, 93128 Regenstauf (DE); SEIFERT, Susan, 09130 Chemnitz (DE)
(86) Internationale Anmeldenummer: PCT/EP2016/066714
(87) Internationale Veröffentlichungsnummer: WO 2017/054950

(56) Entgegenhaltungen:
- DE-A1-102007 058 873
- DE-A1-102008 048 051
- US-A- 5 438 232

## Beschreibung

Die Erfindung betrifft ein Bauelement, insbesondere ein elektrokeramisches Bauelement wie einen Vielschichtpiezoaktor.

Elektrokeramische Bauelemente wie Piezoaktoren weisen eine keramische Matrix mit mindestens einer Innenelektrode auf, die im keramischen Körper angeordnet ist und an einer Oberfläche freigelegt ist. Der Piezoaktor kann in Form eines Vielschichtpiezoaktors ausgebildet werden, der eine Vielzahl piezoelektrisch aktiver keramischer Lagen und metallischer Innenelektrodenlagen aufweist, die abwechselnd aufeinander gestapelt sind. Bei einem Vielschichtpiezoaktor weisen die Oberflächen eine Vielzahl streifenförmiger metallischer Innenelektroden und piezoelektrisch aktive keramische Bereiche auf. Ein solcher Piezoaktor wird beispielsweise als Betätigungselement in Einspritzventilen verschiedenster Motortypen für Kraftfahrzeuge eingesetzt.

Ein solcher Vielschichtaktor aus übereinander und alternierend zueinander gestapelten Schichten von Werkstoffschicht und Elektrodenschicht weist üblicherweise, in Draufsicht betrachtet, einen rechteckigen oder quadratischen Querschnitt auf. Er wird an zwei sich gegenüberliegenden Umfangsseiten elektrisch kontaktiert. Zur sog. vollflächigen Kontaktierung, bei der sich die Elektrodenschichten über die gesamte Fläche der Werkstoffschichten erstrecken, so dass keine piezoelektrisch inaktiven bzw. passiven Bereichen vorhanden sind, schlägt die DE 10 2006 003 070 B3 vor, eine jeweilige Isolationsschicht auf einen jeweiligen von zwei geometrisch nicht zusammenhängenden Stapelumfangsbereichen des Stapels, aufzubringen. Dann wird die genaue Position einer jeweiligen der Elektrodenschichten entlang der Stapelumfangsbereiche ermittelt. Anschließend werden mittels Laserstrukturieren erste Kontaktlöcher durch die erste Isolationsschicht der Isolationsschichten hin zu jeder zweiten der Elektrodenschichten erzeugt sowie zweite Kontaktlöcher durch die zweite der Isolationsschichten hin zu den verbleibenden der Elektrodenschichten. Abschließend werden die Isolationsschichten im Wesentlichen ganzflächig mit einem elektrisch leitenden Material bedeckt, wobei die Kontaktlöcher ebenfalls mit dem elektrisch leitenden Material gefüllt werden. Als elektrisch leitendes Material wird beispielsweise ein Leitkleber verwendet.

In der Praxis scheitert die Verwendung eines Leitklebers als elektrisch leitendes Material oft an der zu geringen Haftung des Leitklebers auf der Isolationsschicht. Zudem kann die Anbindung der in dem Leitkleber enthaltenen elektrisch leitfähigen Partikel an die sehr dünnen, freigelegten Oberflächen der Elektrodenschichten teilweise von unterschiedlicher Qualität, d.h. unterschiedlichem Übergangswiderstand, sein. Beides führt zu einer nicht zufriedenstellenden Zuverlässigkeit des Bauelements.

In der DE 10 2008 048 051 A1 wird vorgeschlagen, einen Sammelkontakt, durch den die auf einer Oberseite freigelegten Kontaktlöcher elektrisch miteinander verbunden werden sollen, mittels zweier elektrischer Schichten auszubilden. Die erste, sehr dünne Schicht dient dazu, die mechanische Festigkeit der Verbindung zwischen den Innenelektroden und dem Sammelkontakt zu erhöhen und/oder den elektrischen Widerstand zu reduzieren. Diese Schicht dient somit im Wesentlichen als Haftvermittler, während die zweite Schicht des Sammelkontakts, welche überwiegend zur Stromtragfähigkeit beiträgt, als flexibler Leitkleber ausgebildet sein kann.

Ein Nachteil des in der DE 10 2008 048 051 A1 beschriebenen Aufbaus besteht darin, dass die erste, sehr dünne Schicht aufgrund der im Einsatz eines Vielschichtaktors auftretenden hohen Temperaturen in die keramische Matrix diffundieren kann. Dies hat über die Zeit zur Folge, dass die erste, sehr dünne Schicht verschwindet und die Funktion der Haftvermittlung dadurch reduziert oder sogar eliminiert ist. Dadurch ist die Gefahr eines Bauteilausfalls aufgrund der hohen dynamischen Belastung sehr hoch, da dann die zweite, dickere Schicht sich von der keramischen Matrix soweit ablösen kann, dass kein elektrischer Kontakt zu zumindest einzelnen der Elektrodenschichten gegeben ist.

Die DE 10 2007 058 873 A1 offenbart ein piezoelektrisches Bauteil mit einer Außenelektrode, die eine Gasphasen-Abscheidung mit mehreren Schicht aufweist, auf die die Außenelektrode aufgebracht ist.

Die US 5 438 232 A offenbart einen piezoelektrischen Aktuator, bei dem eine Außenelektrode aus zwei Schichten gebildet ist.

Es ist Aufgabe der vorliegenden Erfindung, ein Bauelement, insbesondere ein piezoelektrisches Bauelement wie einen Vielschichtaktor, anzugeben, der funktional und/oder baulich derart verbessert ist, dass die Wahrscheinlichkeit eines Ausfalls verringert ist.

Diese Aufgabe wird gelöst durch ein Bauelement gemäß den Merkmalen des Anspruches 1. Vorteilhafte Ausgestaltungen ergeben sich aus den abhängigen Patentansprüchen.

Es wird ein Bauelement vorgeschlagen, das eine keramische Matrix, zumindest eine Innenelektrode, die in der keramischen Matrix angeordnet ist und an einer ersten Oberfläche freigelegt ist, zumindest einen elektrisch leitenden Sammelkontakt, der mit der Elektrode elektrisch verbunden ist, eine Isolationsschicht auf einer Oberfläche der keramischen Matrix, die zwischen dem Körper und dem Sammelkontakt angeordnet ist, wobei die Isolationsschicht mindestens eine Öffnung aufweist, die zumindest einen Teil der Innenelektrode freilegt, und eine weitere, elektrisch leitende Schicht, die zwischen der Innenelektrode und dem Sammelkontakt sowie zwischen der Isolationsschicht und dem Sammelkontakt angeordnet ist, umfasst. Das Bauelement zeichnet sich dadurch aus, dass die weitere Schicht als Multilayer-Schicht mit zumindest zwei Schichten ausgebildet ist, wobei die Multilayer-Schicht als erste Schicht eine Stromkollektorschicht, die an den Sammelkontakt grenzt, und als zweite Schicht eine Diffusionssperrschicht, die an die Isolationsschicht und die Innenelektrode grenzt, umfasst. Dabei besteht die Stromkollektorschicht(30A), die an den Sammelkontakt (8) grenzt, aus Silber-Palladium und sorgt für eine Haftvermittlung zu dem Sammelkontakt (8).

Die mindestens zwei Schichten umfassende Multilayer-Schicht vereint eine Mehrzahl von Funktionen auf sich. Zum einen erfolgt eine Haftvermittlung zu dem Sammelkontakt sowie der keramischen Matrix bzw. der Isolationsschicht. Andererseits ist die Multilayer-Schicht elektrisch leitfähig, um einen Strom zwischen der zumindest einen Innenelektrode und dem Sammelkontakt zu leiten. Die Stromkollektorschicht weist eine Zusammensetzung auf, dass eine Diffusion aus der Multilayer-Schicht vermieden wird. Darüber hinaus wird durch die zweite Schicht eine Diffusionssperre in Richtung der keramischen Matrix bereitgestellt.

Durch die zuletzt genannte Funktionalität der Diffusionssperrschichten kann sichergestellt werden, dass auch bei hohen Temperaturen, denen das Bauelement im Betrieb ausgesetzt ist, keine Diffusion der Materialien der Multilayer-Schicht in die keramische Matrix erfolgt. Dadurch bleibt die weitere Schicht dauerhaft erhalten, wodurch die Gefahr der eingangs beschriebenen Schwächung bzw. eines Bauelementausfalls eliminiert ist. Darüber hinaus weist die Diffusionssperrschicht eine gute Haftung zu der Isolationsschicht und der keramischen Matrix auf. Die Stromkollektorschicht, die an den Sammelkontakt grenzt, sorgt für eine gute Haftvermittlung zu dem Sammelkontakt. Darüber hinaus kann optional ein Schutz gegen Oxidation durch eine Passivierungsschicht bereitgestellt werden.

Somit kann gleichzeitig eine gute Haftung und eine Unterdrückung von Diffusions- und/oder Migrationsvorgängen aus bzw. in die keramische Matrix unterdrückt werden, da die Multilayer-Schicht in ihrer Zusammensetzung auf eine geringe Migrationsneigung angepasst werden kann.

Die erste Schicht der Multilayer-Schicht, d.h. die Passivierungsschicht, ist gemäß einer zweckmäßigen Ausgestaltung dicker als die zweite Schicht der Multilayer-Schicht, d.h. der Diffusionssperrschicht. Dadurch kann durch geeignete Materialauswahl eine gute elektrische Leitfähigkeit der Multilayer-Schicht und ein geringer Übergangswiderstand zu dem Sammelkontakt bereitgestellt werden.

Die erste Schicht der Multilayer-Schicht kann eine Schichtdicke zwischen 70 und 100 nm aufweisen. Demgegenüber kann die zweite Schicht der Multilayer-Schicht eine Schichtdicke zwischen 5 und 15 nm aufweisen. Die erste und die zweite Schicht können durch ein Vakuumabscheideverfahren wie PVD (Physical Vapor Deposition), Sputtern, Bedampfen oder Bogenentladung (Arc), z.B. unmittelbar hintereinander, auf die mit der Isolationsschicht bedeckte keramische Matrix aufgebracht werden.

Die erste Schicht der Multilayer-Schicht besteht erfindungsgemäß aus Silber-Palladium, z.B. einer Silber-Palladium-Legierung. Hierdurch ist sichergestellt, dass eine gute Haftung an dem Sammelkontakt, welcher z.B. aus einer Leitkleberschicht besteht, gegeben ist. Darüber hinaus wird eine gute elektrische Leitfähigkeit sichergestellt.

Demgegenüber kann die zweite Schicht der Multilayer-Schicht Titan, und optional Palladium, umfassen. Durch diese Materialien ist sichergestellt, dass keine Diffusionsprozesse von der zweiten Schicht der Multilayer-Schicht in Richtung der keramischen Matrix stattfinden.

Gemäß einer weiteren Ausgestaltung ist die Schichtdicke des Sammelkontakts wesentlich größer als die Schichtdicke der Multilayer-Schicht.

Gemäß einer weiteren Ausgestaltung kann die Multilayer-Schicht als dritte Schicht eine Antioxidationsschicht umfassen, die zwischen der ersten Schicht der Multilayer-Schicht und dem Sammelkontakt angeordnet ist. Die dritte Schicht kann z.B. ein Edelmetall umfassen. Dadurch kann eine Oxidation vermieden werden, unabhängig davon, mit welcher Zeitverzögerung das Material des Sammelkontakts nach dem Erzeugen der Multilayer-Schicht auf die Multilayer-Schicht aufgebracht wird. Die dritte Schicht kann als Passivierungsschicht angesehen werden.

Gemäß einer weiteren Ausgestaltung ist das Bauelement ein Vielschichtpiezoaktor, der eine Vielzahl von piezoelektrisch aktiven Lagen und eine Vielzahl von elektrisch leitenden Innenelektrodenlagen aufweist. Die piezoelektrisch aktiven Lagen und die elektrisch leitenden Innenelektrodenlagen sind abwechselnd aufeinander in einer Stapelrichtung gestapelt, wobei sich die erste Oberfläche in der Stapelrichtung erstreckt und jede zweite Innenelektrodenlage einen Bereich der ersten Oberfläche bildet und mit dem Sammelkontakt elektrisch verbunden ist, wobei die weiteren Innenelektrodenlagen von dem Sammelkontakt elektrisch isoliert sind.

Bei einem Vielschichtpiezoaktor erstreckt sich die erste Oberfläche in Stapelrichtung. Jede zweite Innenelektrodenlage bildet einen Bereich der ersten Oberfläche und ist mit dem Sammelkontakt elektrisch verbunden, wobei die weiteren Innenelektrodenlagen von dem Sammelkontakt elektrisch isoliert sind. Der Vielschichtpiezoaktor weist somit zwei Gruppen von Innenelektroden auf, die mit unterschiedlichen voneinander elektrisch isolierten Sammelkontakten isoliert sind. Benachbarte Innenelektroden des Stapels sind voneinander elektrisch isoliert und unabhängig voneinander steuerbar.

Insbesondere sind die piezoelektrisch aktiven Lagen vollaktiv. Die Innenelektroden erstrecken sich somit nahezu vollständig über die Fläche bis zu den Randseiten der benachbarten piezoelektrisch aktiven Lagen.

Alternativ können die piezoelektrisch aktiven Lagen nicht piezoelektrisch aktive Bereiche aufweisen. In diesem Beispiel erstrecken sich dann die Innenelektroden nicht bis zum Rand der piezoelektrisch aktiven Lagen.

Typischerweise wird sich jede zweite Innenelektrode zu der Randseite der ersten Oberfläche und nicht zu der Randseite einer zweiten gegenüberliegenden Oberfläche der piezoelektrisch aktiven Lage erstrecken. Dieser unbedeckte Bereich der piezoelektrisch aktiven Lage sieht eine elektrische Isolation der Innenelektrode des Sammelkontakts vor, der auf der zweiten Oberfläche angeordnet ist. Die zweite Gruppe von Innenelektroden streckt sich zum Rand der zweiten Oberfläche und nicht zum Rand der ersten Oberfläche der piezoelektrisch aktiven Lage hin.

Wenn das Bauelement eine zweite Oberfläche aufweist, die gegenüber der ersten Oberfläche angeordnet ist und eine Vielzahl der abwechselnden piezoelektrischen Lagen und elektrisch leitenden Innenelektrodenlagen aufweist, sind die Innenelektrodenlagen, die nicht mit dem Sammelkontakt auf der ersten Oberfläche elektrisch verbunden sind, mit einem zweiten Sammelkontakt auf der zweiten Oberfläche elektrisch verbunden. Der erste Sammelkontakt ist von dem zweiten Sammelkontakt elektrisch isoliert.

Bei einem vollaktiven Stapel kann die zweite Oberfläche auch eine elektrisch isolierende Schicht mit Öffnungen aufweisen, wobei eine Öffnung jede zweite Innenelektrodenlage auf der zweiten Oberfläche freilegt, die nicht mit dem Sammelkontakt auf der ersten Oberfläche elektrisch verbunden ist. In dieser Weise werden zwei Gruppen von Innenelektroden vorgesehen, die unabhängig voneinander steuerbar und die abwechselnd in dem Stapel in Stapelrichtung angeordnet sind.

Die Erfindung wird nachfolgend näher anhand eines Ausführungsbeispiels in der Zeichnung erläutert. Es zeigen:
- Fig. 1: eine schematische, detaillierte Ansicht eines Vielschichtpiezoaktors nach einem Ausführungsbeispiel der vorliegenden Erfindung,
- Fig. 2: eine vergrößerte Ansicht eines ersten Ausführungsbeispiels einer in dem Vielschichtaktor eingesetzten Multilayer-Schicht, und
- Fig. 3: eine vergrößerte Ansicht eines zweiten Ausführungsbeispiels einer in dem Vielschichtaktor eingesetzten Multilayer-Schicht.

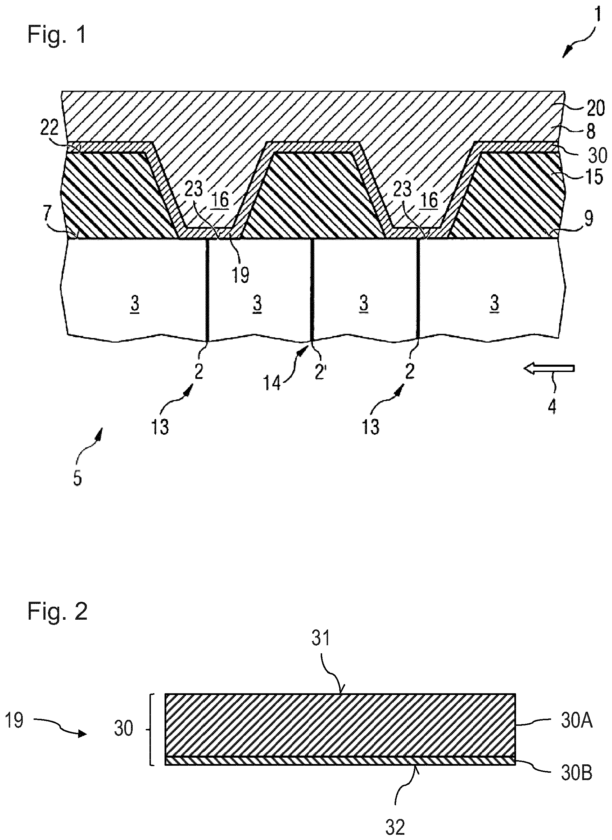

Fig. 1 zeigt eine schematische detaillierte Ansicht eines Vielschichtaktors 1, der eine Vielzahl von Innenelektrodenlagen 2, 2' und eine Vielzahl von piezoelektrisch aktiven Lagen 3 aufweist. Der Vielschichtaktor 1 dient beispielsweise als Betätigungselement in einem Einspritzventil eines Kraftfahrzeugmotors. Die Innenelektrodenlagen 2, 2' und die piezoelektrisch aktiven Lagen 3 sind abwechselnd aufeinander in einer Stapelrichtung 4 gestapelt und bilden einen mehrlagigen Körper 5. Der mehrlagige Körper 5 kann als Werkstoffverbund bezeichnet werden, der aus einer keramischen Matrix und Innenelektroden in Form der Innenelektrodenlagen besteht.

Die Innenelektrodenlagen 2 bestehen in einer dem Fachmann bekannten Weise jeweils aus einem elektrisch leitenden Material, insbesondere einem Metall oder einer Legierung wie Silber-Palladium (Ag-Pd). Die piezoelektrisch aktiven Lagen 3 bestehen aus einem Material, das den piezoelektrischen Effekt aufweist, d.h. beim Anlegen eines elektrischen Feldes verformt sich das Material mechanisch. Diese mechanische Verformung erzeugt eine nutzbare Dehnung und/oder Kraft an den in Fig. 1 nicht dargestellten Endflächen, so dass sich der Stapel in Stapelrichtung 4 dehnen oder zusammenziehen kann. Dadurch kann der Stapel als Aktor verwendet werden.

Die piezoelektrisch aktiven Lagen bestehen aus einer Keramik, insbesondere PZT (Blei-Zirkonat-Titanat). Die Innenelektrodenlagen 2, 2' erstrecken sich über die gesamte Fläche der benachbarten piezoelektrisch aktiven Lagen 3 sowie zu den Randseiten des Stapels und bilden dort einen Teil 23 der Oberfläche 7 des Körpers 5 des Piezoaktors 1. Der Teil 23 der Innenelektrode 2 ist an der Oberfläche 7 freigelegt und folglich frei von der keramischen Matrix des Körpers. Diese Anordnung des Vielschichtpiezoaktors wird als vollaktiver Piezoaktorstapel bezeichnet.

Ein elektrischer Kontakt zu den jeweiligen Innenelektroden 2, die in dem Körper 5 angeordnet sind, erfolgt mit Sammelkontakten, wobei in Fig. 1 lediglich ein Sammelkontakt 8 dargestellt ist. Der Sammelkontakt 8 ist auf einer Randseite des Körpers 5 angeordnet. Der andere, nicht dargestellte Sammelkontakt ist auf der gegenüberliegenden Randseite des Körpers 5 angeordnet. Der Sammelkontakt 8 und der andere Sammelkontakt sind elektrisch voneinander isoliert.

Jede Innenelektrode 2 ist mit dem Sammelkontakt 8 elektrisch verbunden, während jede Innenelektrode 2' mit dem nicht dargestellten anderen Sammelkontakt 8 verbunden ist, so dass zwei Gruppen von Innenelektroden 13, 14 vorgesehen sind, die elektrisch voneinander isoliert sind. Jede zweite Innenelektrode 2 in der Stapelrichtung 4 ist mit dem ersten Sammelkontakt 8 elektrisch verbunden und bildet somit die erste Gruppe 13 von Innenelektroden 2. Der andere, zweite Sammelkontakt ist mit dem Innenelektroden 2' elektrisch verbunden, die die zweite Gruppe 14 von Innenelektroden 2' bilden. Benachbarte Innenelektroden 2, 2' in der Stapelrichtung 4 gehören zu unterschiedlichen Gruppen 13, 14. Eine Spannung wird zwischen den benachbarten Innenelektroden 2, 2' des Stapels 1 angelegt, so dass die zwischen den Innenelektroden 2, 2' angeordneten piezoelektrisch aktiven Lagen 3 mechanisch reagieren.

Um einen Kurzschluss zwischen den zwei Gruppen 13, 14 von Innenelektroden 2, 2' sowie zwischen der Sammelelektrode 8 und der anderen, nicht dargestellten Sammelelektrode zu vermeiden, ist eine elektrisch isolierende Schicht 15 auf den Randseiten (dargestellt ist lediglich die Isolationsschicht 15 auf der Randseite 9) des Körpers 5 mit den Sammelkontakten 8 angeordnet.

Die elektrisch isolierende Schicht 15 weist Öffnungen 16 auf, die die Oberfläche 23 der Innenelektrodenlagen 2 freilegen, die einen Teil der Oberfläche 7 des Körpers 5 bildet. Insbesondere legen die Öffnungen 16 der elektrisch isolierenden Schicht 15 die erste Gruppe 13 von Innenelektroden 2 auf der Randseite 9 und die zweite Gruppe 14 von Innenelektroden 2' auf der anderen, nicht dargestellten, gegenüberliegenden Randseite frei.

Auf der Randseite 9 ist die zweite Gruppe 14 von Innenelektroden 2' von der elektrisch isolierenden Schicht 15 abgedeckt und von dem darauf angeordneten ersten Sammelkontakt 8 elektrisch isoliert. Auf der zweiten gegenüberliegenden Randseite ist die erste Gruppe 13 von Innenelektroden 2 von der elektrisch isolierenden Schicht 15 abgedeckt und von dem darauf angeordneten anderen Sammelkontakt elektrisch isoliert.

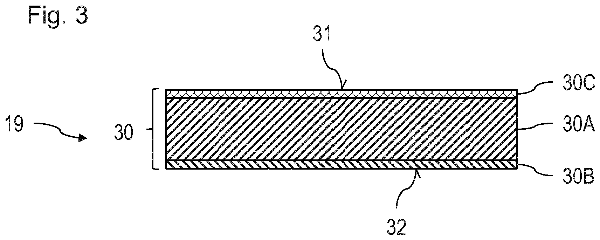

Der Sammelkontakt 8 besteht aus zwei Schichten 19, 20. Die Schicht 20 stellt eine Strom tragende Schicht des Sammelkontakts 8 dar, welche beispielsweise durch einen Leitkleber gebildet ist. Demgegenüber dient die Schicht 19, die nachfolgend unter Bezugnahme auf die Figuren 2 und 3 näher erläutert werden wird, dazu, eine Haftvermittlung zwischen der Strom tragenden Schicht 20 des Sammelkontakts 8 und der isolierenden Schicht 15 sowie den freigelegten Oberflächen 23 des Körpers 5 herzustellen. Die elektrisch leitende Schicht 19 ist somit in den Öffnungen 16 der elektrisch isolierenden Schicht 15 sowie auf der im Querschnitt trapezförmigen isolierenden Schicht 15, d.h. vollflächig auf der Randseite 9 angeordnet und steht in direktem Kontakt und in elektrischer Verbindung mit der freigelegten Innenelektrode 2, die innerhalb der Öffnung 16 angeordnet ist.

Die erste und die zweite elektrisch leitende Schicht 19, 20 erstrecken sich somit über die gesamte Randseite 9 des Vielschichtpiezoaktors 1 und in den Öffnungen 16 der elektrisch isolierenden Schicht 15. Dabei ist die erste Schicht 19 direkt auf der Oberfläche 22 der elektrisch isolierenden Schicht 15 sowie in den Öffnungen 16 angeordnet. Die zweite Schicht 20 ist auf der ersten Schicht 19 angeordnet. Die erste und die zweite Schicht 19, 20 verbinden die Innenelektroden 2 der ersten Gruppe 13 von Innenelektroden 2 elektrisch miteinander.

Wie erwähnt, dient die leitende Schicht 19 als Haftvermittler, um die mechanische Festigkeit der Verbindung zwischen dem Sammelkontakt 8 und der isolierenden Schicht 15 sowie dem Körper 5 des Piezoaktors 1 zu verbessern. Sie hat jedoch aufgrund ihres Aufbaus, der nachfolgend beschrieben wird, weitere Funktionen.

Erfindungsgemäß ist die erste Schicht 19, wie dies in einem ersten Ausführungsbeispiel in Fig. 2 dargestellt ist, als Multilayer-Schicht 30 ausgebildet. Dabei umfasst die Multilayer-Schicht 30 zwei Schichten 30A, 30B, wobei die erste Schicht 30A eine Stromkollektorschicht ist, die an die Schicht 20 des Sammelkontakts 8 grenzt und die Haftung zu dieser übernimmt. Die zweite Schicht 30B ist ebenfalls eine Haftvermittlungsschicht, die eine geringere Dicke als die erste Schicht 30A aufweist und an die isolierende Schicht 15 und die Oberfläche 23 des Körpers 5 grenzt.

Die Materialzusammensetzung der ersten Schicht 30A ist derart, dass eine Diffusion aus der Multilayer-Schicht 30 vermieden wird. Erfindungsgemäß besteht die erste Schicht aus Silber-Palladium (Ag-Pd). Ihre Dicke beträgt zwischen 70 bis 100 nm. Gleichzeitig dient die erste Schicht 30A innerhalb der Multilayer-Schicht als Stromkollektor. Die Materialzusammensetzung der zweiten Schicht 30B ist derart, dass eine Diffusionssperre in die keramische Matrix gegeben ist. Insbesondere besteht die zweite Schicht 30B aus Titan. Ihre Dicke beträgt zwischen 5 und 15 nm.

In einer zweiten Ausgestaltungsvariante, die in Fig. 3 gezeigt ist, kann auf der von der zweiten Schicht 30B abgewandten Seite der ersten Schicht 30A eine dritte Schicht 30C vorgesehen sein. Die dritte Schicht 30C weist eine wesentlich geringere Dicke als die erste Schicht 30A der Multilayer-Schicht 30 auf. In dieser Ausgestaltungsvariante übernimmt die dritte Schicht 30C die Haftvermittlung zu der Schicht 20, da die dritte Schicht 30C an die Schicht 20 des Sammelkontakts 8 grenzt. Die dritte Schicht 30C übernimmt darüber hinaus die Funktion einer Passivierung und eines Oxidationsschutzes. Sie besteht insbesondere aus Gold, deren Dicke in der Größenordnung der zweiten Schicht 30B liegen kann. Die erste Schicht 30A bildet weiter die Stromkollektorschicht.

Die primäre Funktion der Multilayer-Schicht 30 besteht somit darin, eine Haftvermittlung für die Schicht 20 zu der isolierenden Schicht 15 und dem keramischen Körper 5 in den Öffnungen 16 bereitzustellen. Darüber hinaus weist die Multilayer-Schicht 30 durch die erste Schicht 30A auch eine hohe Leitfähigkeit auf, um die elektrische Anbindung der Schicht 20 an Innenelektroden 2 zu verbessern. Durch die Diffusionssperrschicht (zweite Schicht 30B) kann sichergestellt werden, dass auch bei hohen Temperaturbelastungen keine Diffusion des Materials der Schichten 19 in die keramische Matrix 5 erfolgt. Dadurch kann die Dauerhaftigkeit des Bauelements über einen langen Zeitraum sichergestellt werden. Die optional vorsehbare dritte Schicht 30C bietet einen Oxidationsschutz, so dass einerseits ein geringer elektrischer Widerstand zwischen der Multilayer-Schicht 30 und der Schicht 20 gegeben ist und andererseits auch die Haftungseigenschaften nicht nachteilig beeinflusst werden können.

Das Aufbringen der Schichten der Multilayer-Schicht 30 kann beispielsweise durch ein Vakuumabscheideverfahren wie PVD (Physical Vapor Deposition) oder Sputtern oder Bedampfen oder eine Bogenentladung erfolgen. Das Aufbringen erfolgt vorzugsweise direkt hintereinander, beispielsweise in einer gemeinsamen Fertigungsvorrichtung.

In die Schicht 20 des Sammelkontakts 8 kann darüber hinaus ein flexibles Kontaktierungselement eingebracht werden, so dass eine zusätzliche Redundanz für die Stromleitung zu den Innenelektroden 2 erreicht wird. Ein solches flexibles Kontaktierungselement kann beispielsweise ein gestanztes metallisches Bauteil sein, welches in Draufsicht eine mäanderförmige Struktur aufweist.

## Patentansprüche

1. Bauelement (1), umfassend
- eine keramische Matrix (5);
- zumindest eine Innenelektrode (2), die in der keramischen Matrix (5) angeordnet ist und an einer ersten Oberfläche (7) freigelegt ist;
- zumindest einen elektrisch leitenden Sammelkontakt (8), der mit der Innenelektrode (2) elektrisch verbunden ist;
- eine Isolationsschicht (15) auf einer Oberfläche der keramischen Matrix (5), die zwischen der keramischen Matrix (5) und dem Sammelkontakt (8) angeordnet ist, wobei die Isolationsschicht (15) mindestens eine Öffnung (16) aufweist, die zumindest einen Teil der Innenelektrode(2) freilegt; und
- eine weitere, elektrisch leitende Schicht (19), die zwischen der Innenelektrode (2) und dem Sammelkontakt (8) sowie zwischen der Isolationsschicht (15) und dem Sammelkontakt (8) angeordnet ist;
wobei
die weitere Schicht (19) als Multilayer-Schicht (30) mit zumindest zwei Schichten (30A, 30B) ausgebildet ist, wobei die Multilayer-Schicht (30) als erste Schicht (30A) eine Stromkollektorschicht, die an den Sammelkontakt (8) grenzt, und als zweite Schicht (30B) eine Diffusionssperrschicht, die an die Isolationsschicht (15) und die Innenelektrode (2) grenzt, umfasst, **dadurch gekennzeichnet, dass** die Stromkollektorschicht(30A), die an den Sammelkontakt (8) grenzt, aus Silber-Palladium besteht und für eine Haftvermittlung zu dem Sammelkontakt (8) sorgt.

2. Bauelement nach Anspruch 1, **dadurch gekennzeichnet, dass** die erste Schicht (30A) der Multilayer-Schicht (30) dicker ist als die zweite Schicht (30B) der Multilayer-Schicht (30).

3. Bauelement nach Anspruch 1 oder 2, **dadurch gekennzeichnet, dass** die erste Schicht (30A) der Multilayer-Schicht (30) eine Schichtdicke zwischen 70 und 100 nm aufweist.

4. Bauelement nach einem der vorhergehenden Ansprüche, **dadurch gekennzeichnet, dass** die zweite Schicht (30B) der Multilayer-Schicht (30) eine Schichtdicke zwischen 5 und 15 nm aufweist.

5. Bauelement nach einem der vorhergehenden Ansprüche, **dadurch gekennzeichnet, dass** die zweite Schicht (30A) der Multilayer-Schicht (30) Titan, und optional Palladium, umfasst.

6. Bauelement nach einem der vorhergehenden Ansprüche, **dadurch gekennzeichnet, dass** die Schichtdicke des Sammelkontakts (8) wesentlich größer als die Schichtdicke der Multilayer-Schicht (30) ist.

7. Bauelement nach einem der vorhergehenden Ansprüche, **dadurch gekennzeichnet, dass** die Multilayer-Schicht (30) als dritte Schicht (30C) eine Antioxidationsschicht (30C) umfasst, die zwischen der ersten Schicht (30A) der Multilayer-Schicht (30) und dem Sammelkontakt (8) angeordnet ist.

8. Bauelement nach Anspruch 7, **dadurch gekennzeichnet, dass** die dritte Schicht (30C) ein Edelmetall umfasst.

9. Bauelement (1) nach einem der vorhergehenden Ansprüche, **dadurch gekennzeichnet, dass** das Bauelement (1) ein Vielschichtpiezoaktor ist, der eine Vielzahl von piezoelektrisch aktiven Lagen (3) und eine Vielzahl von elektrisch leitenden Innenelektrodenlagen (2, 2') aufweist, und wobei die piezoelektrisch aktiven Lagen (3) und die elektrisch leitenden Innenelektrodenlagen (2, 2') abwechselnd aufeinander in einer Stapelrichtung (4) gestapelt sind, wobei sich die erste Oberfläche (7) in der Stapelrichtung (4) erstreckt und dass jede zweite Innenelektrodenlage (2) einen Bereich der ersten Oberfläche (7) bildet und mit dem Sammelkontakt (8) elektrisch verbunden ist, wobei die weiteren Innenelektrodenlagen (2') von dem Sammelkontakt (8) elektrisch isoliert sind.

10. Bauelement (1) nach Anspruch 9, **dadurch gekennzeichnet, dass** das Bauelement (1) eine zweite Oberfläche aufweist, die gegenüber der ersten Oberfläche (7) angeordnet ist und eine Vielzahl der abwechselnden piezoelektrische Lagen (3) und elektrisch leitende Innenelektrodenlagen (2') aufweist, wobei die Innenelektrodenlagen (2'), die nicht mit dem Sammelkontakt (8) auf der ersten Oberfläche (7) elektrisch verbunden sind, mit einem zweiten Sammelkontakt elektrisch verbunden sind, der von dem ersten Sammelkontakt (8) elektrisch isoliert ist.

## Claims

1. Component (1), comprising
- a ceramic matrix (5);
- at least one internal electrode (2), which is arranged in the ceramic matrix (5) and is exposed at a first surface (7);
- at least one electrically conductive collective contact (8), which is electrically connected to the internal electrode (2);
- an insulation layer (15) on a surface of the ceramic matrix (5), which is arranged between the ceramic matrix (5) and the collective contact (8), wherein the insulation layer (15) has at least one opening (16), which exposes at least one part of the internal electrode (2); and
- a further, electrically conductive layer (19), which is arranged between the internal electrode (2) and the collective contact (8) and also between the insulation layer (15) and the collective contact (8);
wherein
the further layer (19) is embodied as a multilayer (30) having at least two layers (30A, 30B), wherein the multilayer (30) comprises as a first layer (30A) a current collector layer, which adjoins the collective contact (8), and as a second layer (30B) a diffusion barrier layer, which adjoins the insulation layer (15) and the internal electrode (2), **characterized in that** the current collector layer (30A) adjoining the collective contact (8) consists of silver-palladium and provides for adhesion promotion with respect to the collective contact (8).

2. Component according to Claim 1, **characterized in that** the first layer (30A) of the multilayer (30) is thicker than the second layer (30B) of the multilayer (30).

3. Component according to Claim 1 or 2, **characterized in that** the first layer (30A) of the multilayer (30) has a layer thickness of between 70 and 100 nm.

4. Component according to any of the preceding claims, **characterized in that** the second layer (30B) of the multilayer (30) has a layer thickness of between 5 and 15 nm.

5. Component according to any of the preceding claims, **characterized in that** the second layer (30A) of the multilayer (30) comprises titanium, and optionally palladium.

6. Component according to any of the preceding claims, **characterized in that** the layer thickness of the collective contact (8) is significantly greater than the layer thickness of the multilayer (30).

7. Component according to any of the preceding claims, **characterized in that** the multilayer (30) comprises as a third layer (30C) an antioxidation layer (30C), which is arranged between the first layer (30A) of the multilayer (30) and the collective contact (8).

8. Component according to Claim 7, **characterized in that** the third layer (30C) comprises a noble metal.

9. Component (1) according to any of the preceding claims, **characterized in that** the component (1) is a multilayer piezo actuator comprising a multiplicity of piezoelectrically active plies (3) and a multiplicity of electrically conductive internal electrode plies (2, 2'), and wherein the piezoelectrically active plies (3) and the electrically conductive internal electrode plies (2, 2') are stacked alternately one on top of another in a stacking direction (4), wherein the first surface (7) extends in the stacking direction (4), and **in that** every second internal electrode ply (2) forms a region of the first surface (7) and is electrically connected to the collective contact (8), wherein the further internal electrode plies (2') are electrically insulated from the collective contact (8).

10. Component (1) according to Claim 9, **characterized in that** the component (1) has a second surface, which is arranged opposite the first surface (7) and has a multiplicity of the alternating piezoelectric plies (3) and electrically conductive internal electrode plies (2'), wherein the internal electrode plies (2') which are not electrically connected to the collective contact (8) on the first surface (7) are electrically connected to a second collective contact, which is electrically insulated from the first collective contact (8).

## Revendications

1. Composant (1), comprenant
- une matrice céramique (5) ;
- au moins une électrode interne (2) qui est disposée dans la matrice céramique (5) et est à découvert sur une première surface (7) ; et
- au moins un contact collecteur électroconducteur (8) qui est relié électriquement à l'électrode interne (2) ;
- une couche isolante (15) sur une surface de la matrice céramique (5), qui est disposée entre la matrice céramique (5) et le contact collecteur (8), dans lequel la couche isolante (15) comprend au moins une ouverture (16) qui met à découvert au moins une partie de l'électrode interne (2) ; et
- une autre couche électroconductrice (19) qui est disposée entre l'électrode interne (2) et le contact collecteur (8) et entre la couche isolante (15) et le contact collecteur (8) ;
dans lequel
l'autre couche (19) est réalisée en tant que couche multicouche (30) comportant au moins deux couches (30A, 30B), dans lequel la couche multicouche (30) comprend, en tant que première couche (30A), une couche collectrice de courant, qui jouxte le contact collecteur (8) et, en tant que deuxième couche (30B), une couche barrière de diffusion, qui jouxte la couche isolante (15) et l'électrode interne (2), **caractérisé en ce que** la couche collectrice de courant (30A) qui jouxte le contact collecteur (8) est constituée d'argent-palladium et confère une adhérence au contact collecteur (8).

2. Composant selon la revendication 1, **caractérisé en ce que** la première couche (30A) de la couche multicouche (30) est plus épaisse que la deuxième couche (30B) de la couche multicouche (30).

3. Composant selon la revendication 1 ou 2, **caractérisé en ce que** la première couche (30A) de la couche multicouche (30) présente une épaisseur de couche comprise entre 70 et 100 nm.

4. Composant selon l'une quelconque des revendications précédentes, **caractérisé en ce que** la deuxième couche (30B) de la couche multicouche (30) présente une épaisseur de couche comprise entre 5 et 15 nm.

5. Composant selon l'une quelconque des revendications précédentes, **caractérisé en ce que** la deuxième couche (30A) de la couche multicouche (30) comprend du titane, et facultativement du palladium.

6. Composant selon l'une quelconque des revendications précédentes, **caractérisé en ce que** l'épaisseur de couche du contact collecteur (8) est sensiblement supérieure à l'épaisseur de couche de la couche multicouche (30).

7. Composant selon l'une quelconque des revendications précédentes, **caractérisé en ce que** la couche multicouche (30) comprend, en tant que troisième couche (30C), une couche anti-oxydation (30C) disposée entre la première couche (30A) de la couche multicouche (30) et le contact collecteur (8).

8. Composant selon la revendication 7, **caractérisé en ce que** la troisième couche (30C) comprend un métal noble.

9. Composant (1) selon l'une quelconque des revendications précédentes, **caractérisé en ce que** le composant (1) est un actionneur piézoélectrique multicouche qui comporte une pluralité de couches actives piézoélectriques (3) et une pluralité de couches d'électrodes internes électroconductrices (2, 2'), et dans lequel les couches actives piézoélectriques (3) et les couches d'électrodes internes électroconductrices (2, 2') sont empilées alternativement les unes sur les autres dans une direction d'empilement (4), dans lequel la première surface (7) s'étend dans la direction d'empilement (4) et **en ce que** chaque deuxième couche d'électrode interne (2) forme une région de la première surface (7) et est reliée électriquement au contact collecteur (8), dans lequel les autres couches d'électrodes internes (2') sont électriquement isolées du contact collecteur (8).

10. Composant (1) selon la revendication 9, **caractérisé en ce que** le composant (1) présente une deuxième surface qui est disposée à l'opposé de la première surface (7) et comporte une pluralité de couches piézoélectriques (3) et de couches d'électrodes internes électroconductrices (2') alternées, dans lequel les couches d'électrodes internes (2') qui ne sont pas reliées électriquement au contact collecteur (8) sur la première surface (7) sont reliées électriquement à un deuxième contact collecteur qui est électriquement isolé du premier contact collecteur (8).
